# FASCICULE DE BREVET EUROPEEN

(11) **EP 2 798 684 B1**
(45) Date de publication et mention de la délivrance du brevet: **06.04.2016**
(21) Numéro de dépôt: 12820868.3
(22) Date de dépôt: 28.12.2012
(51) Int. Cl.: H01L 51/52

(54) **DISPOSITIF OLED A EMISSION PAR L'ARRIERE**
UNTEN EMITTIERENDE OLED VORRICHTUNG
BOTTOM EMITTING OLED DEVICE

(30) Priorité: 30.12.2011 FR 1162589
(43) Date de publication de la demande: 05.11.2014
(73) Titulaire: Saint-Gobain Glass France, 92400 Courbevoie (FR)
(72) Inventeur: CHERY, Vincent, F-75013 Paris (FR); LIENHART, Fabien, San Diego, California 92108 (US); SAUVINET, Vincent, F-Grenoble 38000 (FR)
(74) Mandataire: Ribeaudeau, Marion Christine
(86) Numéro de dépôt international: PCT/FR2012/053099
(87) Numéro de publication internationale: WO 2013/098535

(56) Documents cités:
- WO-A1-2011/085917
- WO-A1-2011/101766
- US-A1- 2008 197 371

## Description

La présente invention a pour objet un dispositif à diode électroluminescent organique.

Les systèmes électroluminescents organiques connus ou OLED (pour « Organic Light Emitting Diodes » en anglais) comportent un empilement de couches électroluminescentes organiques alimentées en électricité par des électrodes l'encadrant sous forme de couches minces électroconductrices. Lorsqu'une tension est appliquée entre les deux électrodes, le courant électrique traverse la couche organique, générant ainsi de la lumière par électroluminescence.

Dans un dispositif OLED à émission par l'arrière (bottom OLED en anglais), l'électrode supérieure, ou cathode, est une couche métallique réfléchissante typiquement avec résistance par carré inférieure ou égale à 0,1 Ω/carré et l'électrode inférieure ou anode, est une couche transparente, déposée sur un substrat verre ou plastique laissant passer la lumière émise, de résistance par carré de plusieurs ordres de grandeurs supérieures.

Le document WO99/02017 constate qu'une très grande différence de résistance par carré entre l'anode et la cathode conduit à la fois une inhomogénéité de la luminance, une diminution de la durée et de la fiabilité, tout particulièrement pour des dispositifs de grandes tailles. Aussi, il propose un dispositif à diode électroluminescente organique avec une anode transparente de résistance par carré donnée R1 et une cathode avec une résistance par carré R2 donnée proche, le ratio r = R2/R1 étant compris entre 0,3 et 3.

A titre d'exemple, l'anode est une couche d'ITO de résistance par carré 10 ohms et la cathode est une couche mince d'ytterbium de résistance par carré 9,9 ohms soit r autour de 1.

Le gain en homogénéité n'est cependant pas encore optimal et même n'est pas certain pour toutes les configurations d'OLED.

Le document US2008/0197371 décrit un dispositif OLED comportant deux contacts électriques d'anode de part et d'autre de la région anodique ainsi que deux contacts électriques de cathode agencés sur les bords de la cathode.

Le document WO2011/101766 décrit une OLED transparente ayant un agencement particulier pour les contacts électriques d'anode et de cathode.

Le document WO2011/085917 décrit un dispositif optoélectronique ayant une intensité de lumière homogène.

Aussi, la présente invention a pour objet un dispositif à diode électroluminescent organique, dit OLED, comportant un substrat transparent avec une première face principale comportant un empilement comprenant dans cet ordre en partant de ladite première face :
- (directement sur la première face ou sur une sous couche par exemple) une électrode inférieure formant anode, qui est transparente, comportant de préférence au moins une couche électroconductrice, anode de résistance par carré donnée R1, notamment R1 inférieure à 30 Ohm/carré voire inférieure ou égale à 15 Ohm/carré ou même 10 Ohm/carré, la dimension caractéristique de la surface anodique étant de préférence d'au moins 2 cm, voire 5 cm,
- un système électroluminescent organique au-dessus de l'anode,
- une électrode supérieure formant cathode, au-dessus du système électroluminescent organique (voire directement sur le système), comportant de préférence une couche électroconductrice, cathode de résistance par carré donnée R2, cathode de préférence d'épaisseur donnée constante, avec un ratio r = R2/R1 allant de 0,1 à 5
l'anode, le système électroluminescent organique et la cathode définissant ainsi une zone commune dite active (correspondant à la surface éclairante moins des éventuels contacts d'anode internes, si trop opaques).

Le dispositif OLED comporte en outre :
- un premier contact d'anode adapté, de préférence de type étendu voire sous forme d'une pluralité de contacts ponctuels (rapprochés),
- un deuxième contact d'anode adapté, de préférence de type étendu voire sous forme d'une pluralité de contacts ponctuels (rapprochés), espacé et en regard du premier contact adapté,
   les premier et deuxième contacts formant deux cotés opposés (non adjacents) d'une région de l'anode, dite première région anodique, délimitée en outre par un premier bord dit libre de la zone active et par un deuxième bord dit libre de la zone active opposé au premier bord libre,
- un premier contact électrique de cathode, qui est :
   - agencé au-dessus de la zone active, couvrant partiellement la région de la cathode au-dessus de la première région anodique,
   - de surface donnée, dite surface de contact, inférieure à la superficie de la zone active et à la superficie de la première région anodique,
   - décalé du premier contact d'anode adapté et du deuxième contact d'anode adapté, en tout point de la surface de contact.
      Pour (au moins la majorité voire 80% et de préférence pour) chaque point B1 du premier contact adapté, en définissant une distance D1 entre ledit point B1 et le point C1 de la surface de contact le plus proche dudit point B1, et en définissant une distance L1 entre ledit point B1 et un point X1 du deuxième contact adapté, en passant par C1 alors on définit les critères suivants :
      - si 0,1 ≤ r < 1,75, alors 10% < D1/L1 < 50%,
      - si 1,75:5 ≤ r < 2,5, alors 10% < D1/L1 < 45%,
      - si 2,5 ≤ r < 3, alors 10% < D1/L1 < 40%,
      - si 3 ≤ r ≤ 5, alors 10% < D1/L1 < 35%,

      Et pour (au moins la majorité voire 80% et de préférence pour) chaque point B2 du deuxième contact adapté, en définissant une distance D2 entre ledit point B2 et le point C2 de la surface de contact le plus proche dudit point B2, et en définissant une distance L2 entre ledit point B2 et un point X2 du premier contact adapté, en passant par C2, alors on définit les critères suivants :
      - si 0,1 ≤ r < 1,75, alors 10% < D2/L2 < 50%,
      - si 1,75 ≤ r < 2,5, alors 10% < D2/L2 < 45%,
      - si 2,5 ≤ r < 3, alors 10% < D2/L2 < 40%,
      - si 3 ≤ r ≤ 5, alors 10% < D2/L2 < 35%.

Le dispositif OLED comporte en outre au-dessus du système électroluminescent organique, en s'éloignant de la première face, un réflecteur couvrant la zone active.

Plus rigoureusement, D1 (respectivement D2) est la distance entre B1 (respectivement B2) et la projection (orthogonale) de C1 (respectivement de C2) sur l'anode ou mieux dans le plan passant par B1 (respectivement B2) parallèle à l'anode, mais compte-tenu de la faible hauteur de l'OLED, cela ne change pas les critères définis ci-dessus.

Et de même plus rigoureusement L1 (respectivement L2) est la distance entre B1 (respectivement B2) et X1 (respectivement X2), en passant par la projection orthogonale de C1 (respectivement de C2) dans le plan passant par B1 (respectivement B2) parallèle à l'anode.

On peut préférer donc définir D1 et L1 dans le plan passant par B1 parallèle à l'anode et définir D2 et L2 dans le plan passant par B2 parallèle à l'anode.

Selon l'invention, on entend par contact adapté d'anode (le premier contact d'anode adapté comme le deuxième contact d'anode adapté), un contact électrique ayant une conduction suffisante pour que, lorsque l'OLED est en fonctionnement, la tension soit la même en tout point du contact adapté. Il en résulte de cette propriété de conduction, qu'entre deux points du contact adapté, la variation de luminance à proximité de ces deux points est inférieure à 5%. Le rôle du contact adapté d'anode est donc de distribuer un même potentiel électrique sur toute sa surface.

Selon l'invention, le premier contact électrique de cathode a une conduction suffisante pour que, lorsque l'OLED est en fonctionnement, la tension soit la même en tout point du premier contact de cathode. Il en résulte de cette propriété de conduction, qu'entre deux points de ce contact de cathode, la variation de luminance à proximité de ces deux points est inférieure à 5%. Le rôle de ce contact de cathode est donc de distribuer un même potentiel électrique sur toute sa surface.

Le but de cette invention est de fabriquer l'OLED la plus grande possible satisfaisant un critère d'homogénéité de luminance pré-requis avec une anode de R1 donnée et une résistance de couche organique rorg donnée dans une configuration avec deux contacts d'anode opposés.

La Demanderesse a constaté que les positions des connectiques d'anode et de cathode, notamment leur positionnement l'une par rapport à l'autre, ainsi que leurs formes étaient critiques. Pour un véritable gain en homogénéité, il est ainsi crucial :
- de choisir judicieusement les contacts d'anode, notamment leur résistance pour qu'ils soient adaptés,
- de placer correctement le premier contact de cathode,
- et d'éloigner suffisamment le premier contact de cathode des contacts d'anode adaptés opposés.

On obtient ainsi une différence de potentiels la plus constante possible entre la cathode et l'anode sur toute la surface éclairante.

La dénomination bords opposés est prise au sens large et incorpore deux zones opposées d'une région anodique arrondie (disque, contour ovoïde, etc) et s'oppose en outre au terme adjacent.

D1 (ou D2) peut être constant quelque soit le point B1 (ou B2) ou varier tout en restant avec le ratio D1/L1 (ou D2/L2) selon l'invention qui dépend drastiquement du choix du ratio r.

La cathode est alimentée électriquement à un potentiel Vc, telle que la différence de potentiel(s) entre anode et cathode est apte pour l'éclairage, notamment Vc est à la masse.

On considère qu'une cathode épaisse classique est idéale, c'est-à-dire qu'elle forme en elle-même un contact de cathode (équipotentiel en tout point de la cathode). L'invention se distingue d'une telle cathode de part l'augmentation de la résistance par carré de la cathode R2 et des critères sur la surface de contact.

La cathode est de préférence d'épaisseur donnée constante notamment avec une tolérance en fonction du procédé de fabrication, par exemple ± 10% pour un dépôt type couche mince.

L'OLED selon l'invention tout particulièrement destinée à l'éclairage aussi la dimension caractéristique, i. e. la plus grande dimension, telle que la longueur ou le diamètre, de la première région anodique (ou de la zone active) peut être d'au moins 10 cm voire 15 cm.

Pour une meilleure homogénéisation, le premier contact de cathode est présent dans la région la plus éloignée des contacts d'anode opposés.

C'est en effet dans cette région éloignée que le potentiel d'anode chute le plus drastiquement. Selon l'invention il faut donc compenser par une chute de potentiel dans la cathode, cette chute de potentiel étant générée par le premier contact de cathode selon l'invention.

Pour les formes courantes de région anodiques (polygones, rond, etc), il s'agit naturellement de la région centrale - donc le centre et ses alentours - de la première région anodique.

Ainsi, le premier contact de cathode peut s'étendre avantageusement depuis la région centrale (autrement dit le centre) de la première région anodique vers les premier et deuxième contacts d'anode, voire de préférence vers l'un ou les bords libres de la zone active.

Le terme bord libre est pris au sens large par exemple plusieurs tronçons si la zone active a de nombreux côtés. Il inclut aussi une zone de bord dans le cas d'une zone active arrondie, courbée.

La limite supérieure de D1/L1 (ou (D2/L2) rappelle que le premier contact de cathode selon l'invention s'écarte d'un contact de type ponctuel (ou infiniment fin).

Il importe que le premier contact de cathode présente donc une surface de contact suffisante.

Par exemple, un contact de cathode laissant alors une part de la zone centrale inhomogène n'est pas conforme à l'invention. On peut citer comme contre exemples :
- un contact de cathode en plusieurs morceaux trop espacés entre eux dans la zone centrale de la première région anodique,
- un contact de cathode creux formant un cadre ou un anneau trop fin.

Un autre contre exemple de contact de cathode (non conforme à l'invention) serait un contact de cathode externe à la zone active.

Un autre contre exemple de contact de cathode (non conforme à l'invention) serait en outre un réseau de contacts résistifs ou même adaptés, tel qu'une grille ou des bandes parallèles, occupant seulement la périphérie interne de la zone active (de largeur D1 ou D2) ou l'ensemble de la zone active.

Le contact de cathode selon l'invention ne reproduit pas forcément la symétrie de la zone active et/ou de la première région anodique.

La surface de contact peut être une surface pleine, une surface en grille (agencée pour maintenir un équipotentiel), la surface étant éventuellement étoilée.

En fait, une surface de contact, même pleine, peut être étoilée, et notamment avec des branches plus ou moins épaisses (notamment assimilables à des lignes).

La surface de contact (sensiblement) pleine (notamment une couche déposée sur l'anode) peut présenter des discontinuités de surface, mais inaptes à perturber à sa fonction d'équipotentiel dans la région la plus éloignée des contacts d'anode adaptés opposés.

La surface pleine peut être en particulier convexe au moins en regard des contacts d'anode adaptés. Et, comme déjà indiqué, de préférence la surface de contact pleine n'est pas de type creuse.

On préfère en outre que la zone active soit de type pleine. Dans le cas d'une zone active avec au moins un (fort) rétrécissement, on peut préférer ne pas disposer les contacts d'anode adaptés en regard de ce rétrécissement.

Le premier contact de cathode peut être (sensiblement) centré par rapport aux premier et deuxième contacts d'anode (voire de préférence par rapport aux bords de la zone active si contacts d'anode adaptés externes).

Le premier contact de cathode a par exemple une surface de contact dont le contour est orthogonal aux lignes de courant dans la première région anodique, notamment dans une configuration polygonale de région active (carrée, rectangulaire).

Le premier contact de cathode, notamment centré, peut avoir une surface (sensiblement) homothétique à la surface de la première région anodique,

A tout le moins, le contour du premier contact de cathode en regard du premier contact d'anode peut suivre le contour du premier contact d'anode. Le contour du premier contact de cathode en regard du deuxième contact d'anode peut suivre le contour du deuxième contact d'anode.

Le premier contact de cathode, notamment centré, peut avoir une surface (sensiblement) homothétique à la surface de la zone active si les contacts adaptés sont externes, ceci notamment pour une zone active polygonale.

Le contact de cathode peut être autosupporté et rapporté sur la cathode par exemple un ensemble de fils, en nappe, etc.

De préférence l'épaisseur du premier contact de cathode est constante.

Le premier contact de cathode peut être de préférence continu dans la première région anodique, notamment est une couche pleine (mono ou multicouches), métallique et/ou de préférence la surface de contact n'est pas creuse (au moins au centre).

Pour une homogénéisation encore meilleure on préfère :
- si 0,1 ≤ r < 1,75, alors 20% ≤ D1/L1 < 50% et 20% ≤ D2/L2 < 50%,
- si 1,75 ≤ r < 2,5, alors 20% ≤ D1/L1 ≤ 40%, et 20% ≤ D2/L2 ≤ 40%,
- si 2,5 ≤ r < 3, alors 20% ≤ D1/L1 ≤ 35%, et 20% ≤ D2/L2 ≤ 35%,
- si 3 ≤ r ≤ 5, alors 15% ≤ D1/L1 ≤25% et 15% ≤ D2/L2 ≤25%.

On préfère en particulier les critères suivants
- si 0,1 ≤ r < 1,75, alors 30% ≤ D1/L1 < 50% et 30% ≤ D2/L2 < 50%,
- si 1,75 ≤ r < 2,5, alors 25% ≤ D1/L1 ≤ 35% et 25% ≤ D2/L2 ≤ 35%,
- si 2,5 ≤ r < 3, alors 20% ≤ D1/L1 ≤ 30%, et 20% ≤ D2/L2 ≤ 30%,
- si 3 ≤ r ≤ 5, alors 15% ≤ D1/L1 ≤25% et 15% ≤ D2/L2 ≤ 25%.

La meilleure homogénéisation est obtenue pour 2,5 ≤ r < 3 et 20% ≤ D1/L1 < 30%, 20% < D2/L2 < 30%.

Le premier contact adapté quant à lui peut être une couche pleine ou de type maillage (grille resserrée formant une bande..), voire un ensemble de contacts d'anode ponctuels suffisamment proches pour répartir le courant, par exemple éloignés de moins de quelques mm.

Le premier contact d'anode adapté peut être le long d'un premier bord de la zone active, interne et/ou externe à la zone active. Il peut s'étendre de préférence le long de la majorité voire sensiblement le long de l'ensemble du premier bord. Naturellement le premier bord est distinct des premier et deuxième bords libres.

Et éventuellement le deuxième contact d'anode adapté, interne et/ou externe à la zone active, est le long d'un deuxième bord de la zone active opposée au premier bord, Ces premier et deuxième bords sont de préférence longitudinaux (les plus long des bords de la zone active).

Le premier bord peut regrouper plusieurs côtés d'une zone active en polygone notamment à n > 5 côtés. Autrement dit le premier contact d'anode adapté peut s'étendre sur plusieurs côtés. Il en est de même pour le deuxième contact d'anode adapté.

Le premier contact adapté (comme le deuxième), notamment sensiblement rectiligne, peut donc être périphérique, périphérique pris au sens large donc :
- sur un bord d'anode dépassant du bord du système électroluminescent (et du bord de la cathode au-dessus), donc (au moins en partie) en périphérie externe à la zone active, et notamment séparé des bords de la cathode et de la couche organique par une passivation,
- et/ou sur un bord d'anode couvert par le système électroluminescent (et par la cathode au-dessus) et est passivée par une couche de passivation, telle que du polyimide, donc (au moins en partie) en périphérie interne à la zone active.

Le premier contact adapté périphérique est de préférence à une distance W inférieure à L/10 voire à L/20 du premier bord où L est la distance maximale entre premier et deuxième bord. Le deuxième contact adapté périphérique est de préférence à une distance W inférieure à L/10 voire à L/20 du deuxième bord.

De préférence un contact adapté périphérique longe la périphérie est à distance constante (ou à peu près) de la périphérie de la zone active.

Le premier contact adapté périphérique, externe et/ou interne, est de préférence à une distance inférieure à 10 mm, voire inférieure ou égale à 5 mm du bord le plus proche de la zone active et voire est (en partie) sur le bord de la zone active (en dépassant de part et d'autre).

Le premier et/ou le deuxième contact d'anode adapté peut sensiblement être rectiligne, être courbe....

Le premier contact d'anode adapté peut être sensiblement rectiligne, notamment avec l'ensemble des tangentes au premier contact adapté formant un faisceau de droites dont les angles pris deux à deux sont inférieurs à 30°, et être défini par un premier plan moyen M1.

Le deuxième contact d'anode adapté peut être sensiblement rectiligne, notamment avec l'ensemble des tangentes au deuxième contact adapté formant un faisceau de droites dont les angles pris deux à deux sont inférieurs à 30°, et être défini par un deuxième plan moyen M2.

De préférence l'angle α entre les (premier et deuxième) plans moyens, donc M1 et M2, est inférieur à 45°, voire inférieur ou égal à 30° et encore mieux inférieur ou égal à 10°, voire vaut 0°.

On préfère que les premier et deuxième contacts soient sensiblement parallèles en particulier lorsque la zone active est de type polygonale à au moins quatre bords (ou côtés) et/ou suivant le contour de la zone active étant le plus simple (si contour arrondie).

Le premier contact d'anode adapté peut avoir une longueur LG1. Le deuxième contact d'anode adapté peut avoir une longueur LG2 et de préférence 0,8LG1 < LG2 < 1,2LG1.

Les contacts d'anode adaptés peuvent être chacun sur une moitié distincte de zone active.

De préférence :
- les premier et deuxième contacts d'anode sont périphériques et il n"y a pas d'autre contact d'anode adapté,
- le premier contact d'anode est périphérique, le deuxième contact d'anode est (plus) interne à la zone active (notamment rectiligne et parallèle ou au moins suivant ledit angle α) et il y a alors un troisième contact d'anode adapté, par exemple périphérique, en regard du deuxième contact d'anode, définissant une deuxième région anodique avec le deuxième contact d'anode adapté (adjacente à la première région).

Dans cette deuxième région anodique on utilise alors un deuxième contact de cathode défini comme pour le premier contact de cathode avec un ratio D3/L3 identique au ratio D1/L1 pour le r donné (choisi naturellement pour l'ensemble des régions anodiques).

On peut construire de la même façon une région anodique avec des premier et deuxième contacts d'anode adaptés internes à la zone active (d'autres contacts étant de préférence présents en périphérie).

Plus largement, l'anode peut être contactée par plusieurs groupes de contacts d'anode adaptés opposés définissant une pluralité de régions anodiques. Dans chaque région anodique, le dispositif OLED peut comprendre un contact de cathode (adjacent à un éventuel élément couvrant ou à un miroir de Bragg comme détaillé plus tard) agencé au-dessus de ladite région anodique, de surface donnée inférieure à la superficie de la région anodique, couvrant partiellement la région de la cathode au-dessus de ladite région anodique et décalé des deux contacts d'anode adaptés en tout point C de la surface de contact et répondant aux critères déjà décrits de D/L (D1/L1, D2/L2) en fonction de r (ou r' défini plus tard).

Ainsi les régions anodiques peuvent former un pavage de l'anode (donc de la zone active) avec une maille de préférence rectangulaire, carrée, nid d'abeille...

Les régions anodiques sont de tailles identiques ou distinctes et de formes identiques ou distinctes.

Typiquement la largeur d'un contact d'anode adapté (étendu voire ponctuel) est de l'ordre du cm. II n'y a probablement pas de lumière sortante dans la zone active dotée du premier contact d'anode adapté, car ce dernier est trop opaque.

Par ailleurs, contrairement à l'art antérieur précité, on préserve, via le réflecteur, un niveau de luminance acceptable. Typiquement le réflecteur peut avoir une réflexion lumineuse RL (vers le système organique) d'au moins 80 %.

Le système électroluminescent organique est au-dessus de l'anode :
- notamment directement sur l'anode, en intégrant dans la fonction anode aussi une planarisation éventuelle électroconductrice,
- ou encore directement sur une passivation de contact d'anode adapté interne à la zone active (comme discuté plus tard),
- notamment directement sur l'anode, en intégrant dans la fonction anode aussi une planarisation éventuelle électroconductrice,
- ou encore directement sur une passivation de contact d'anode résistif interne à la zone active (comme discuté plus tard).

Typiquement, le substrat revêtu de l'anode (anode directement sur le substrat ou séparée par une couche par exemple pour l'extraction de lumière) peut avoir une transmission lumineuse d'au moins 70%.

Selon l'invention, on entend par couche mince, une couche (mono ou multicouche en l'absence de précision) d'épaisseur inférieure au micron, voire à 500 nm, voire à 100 nm.

Selon l'invention, on entend par couche une monocouche ou multicouche, ceci en l'absence de précision.

Le dispositif OLED peut comprendre un ou des contacts électriques d'anode dits résistifs, notamment en couche électroconductrice, agencés dans la première région anodique, reliés au premier contact d'anode adapté voire au deuxième contact d'anode adapté 41', contacts résistifs éventuellement interconnectés.

Et le ratio r = R2/R1 allant de 0,1 et 5 est alors remplacé par un ratio r' = R2/R'1 compris allant de 0,1 et 5 dans lequel R'1 est la résistance par carré équivalente de l'ensemble anode et contact(s) résistif(s) dans la première région anodique et l'on conserve les critères pour D1/L1 et D2/L2.

Naturellement on préférera :
- si 0,1 ≤ r' < 1,75, alors 20% ≤ D1/L1 < 50% et 20% ≤ D2/L2 < 50%,
- si 1,75 ≤ r' < 2,5, alors 20% ≤ D1/L1 ≤ 40% et 20% ≤ D2/L2 ≤ 40%,
- si 2,5 ≤ r' < 3 ; alors 20% ≤ D1/L1 ≤ 35%, et 20% ≤ D2/L2 ≤ 35%,
- si 3 ≤ r' ≤ 5, alors 15% ≤ D1/L1 ≤25% et 15% ≤ D2/L2 ≤ 25%.

Les contacts résistifs sont de résistance telle qu'en fonctionnement, certains points du contact résistif sont à un potentiel Vr distinct du potentiel du contact d'anode adapté de plus de 5 % en relation absolue, voire au moins 10% ou même 20%.

La résistance globale de l'anode peut ainsi se définir comme la mise en parallèle de la résistance des contacts résistifs avec la résistance de la couche d'anode transparente.

Le contact résistif peut être en un même matériau que le contact adapté mais beaucoup plus fin par exemple de moins de 1 mm.

A des fins esthétiques, on peut préférer un dispositif OLED dénué d'un ou de plusieurs contacts d'anode adaptés dans la zone active, voire même dénué d'un ou de plusieurs de contacts résistifs d'anode (même si assez fins en général) dans la zone active.

Un contact d'anode (adapté ou résistif) peut être sous forme de couche d'épaisseurs comprises entre 0,2 à 10 µm et de préférence sous forme d'une monocouche en l'un des métaux suivants : Mo, Al, Cr, Nb ou en alliage tel que MoCr, AINb ou sous forme d'une multicouche telle que Mo/Al/Mo ou Cr/Al/Cr.

Il peut aussi s'agir d'un bus bar à l'argent sérigraphié (émail à l'argent) ou déposé par jet d'encre.

Il est déjà connu d'abaisser R1 de l'anode par un maillage assez fin de contacts électriques résistifs, typiquement un réseau métallique carré ou nid d'abeille sur l'anode.

Les brins sont de l'ordre de 50 à 100 µm de large et le pas du réseau est en général de 1/5 mm, ce qui donne un taux d'occultation entre 1 et 5 %.

R'1 peut varier de 0,5 à 5 Ohms par exemple. En pratique, on utilise une multicouche Mo ou Cr (100 nm)/Al (500 nm à 1000 nm)/Mo ou Cr (100 nm) est déposée par exemple sur l'ITO de 140 nm. Cette multicouche est ensuite gravée chimiquement, avec un procédé de photolithographie en général, pour former les contacts résistifs et éventuellement les contacts d'anode adaptés en la même matière mais plus larges.

Ainsi dans la région anodique, tout se passe comme si l'on avait une anode de résistance équivalente à la mise en parallèle de l'anode et du ou des contacts d'anode résistifs.

On a alors une tension dans les contacts résistifs d'anode qui va diminuer progressivement à mesure qu'on s'éloigne des bords de l'OLED.

On peut préférer positionner la connectique de l'anode en dehors de la zone active, c'est pourquoi la connectique (liée au contact d'anode adapté périphérique) est placée dans une zone de contact d'anode dépassant de la zone active.

On peut préférer positionner la connectique de la cathode en dehors de la zone active, c'est pourquoi la connectique liée au contact de cathode est placée dans une zone « de contact de cathode » dépassant de la zone active.

De la même manière, il peut y avoir un ou plusieurs contacts résistifs de cathode, par exemple en couche électroconductrice, reliés au premier contact de cathode, contacts résistifs éventuellement interconnectés et notamment répartis sur l'ensemble de la zone entre le premier contact de cathode et les bords de l'OLED

Dans ce cas, R2 correspond à la résistance par carré équivalente de l'ensemble cathode et contact(s) résistif(s).

Les contacts résistifs sont par exemple de résistance telle qu'en fonctionnement, certains points du contact résistif sont à un potentiel Vr distinct du potentiel du premier contact de cathode V de plus de 2 % en relation absolue, voire au moins 4% ou même 8%.

Dans un bord libre de contact d'anode, on peut alimenter ainsi la cathode :
- en faisant déborder le contact de cathode par l'une de ses extrémités en dehors de la zone active, cette zone n'étant plus définie comme une zone de contact de cathode mais comme une zone de connectique cathode
- ou en faisant déborder le réflecteur sur un côté en dehors de la zone active.

Par ailleurs, du fait de l'adaptation de R2, la cathode peut être transparente ou semi-réfléchissante, notamment de réflexion RL inférieure à 80%, voire inférieure ou égale à 60%, voire 50%.

La cathode laisse passer la lumière émise, de préférence sans trop absorber.

Dans une première configuration (avec la cathode transparente ou semi transparente), le réflecteur peut comporter un élément couvrant réfléchissant métallique, notamment en couche(s) (mince(s)), au-dessus de la cathode en s'éloignant de la première face principale, l'élément couvrant étant séparé de la cathode par un élément isolant électrique, notamment en couche, dit intercalaire.

Le premier contact de cathode, adjacent à l'intercalaire (et au moins partiellement entouré par l'intercalaire), peut aussi faire partie du réflecteur et est de préférence en contact voire électriquement couplé à l'élément couvrant réfléchissant. L'élément couvrant réfléchissant peut être :
- une couche, déposée par dépôt physique en phase vapeur sur l'intercalaire, ou sur une face interne d'un contre élément (verre, film plastique..) rapporté contre l'intercalaire (en contact optique de préférence)
- une feuille métallique : Cu, Inox, Alu, Ag ...

L'élément couvrant réfléchissant, de préférence à couche, est par exemple à base d'au moins un métal choisi parmi Al, Ag, Cu, Mo, Cr.

L'intercalaire peut être choisi pour laisser passer la lumière émise, de préférence sans trop absorber. Par exemple l'intercalaire est transparent, de préférence de TL > 90 %, et peu absorbant notamment A < 3 %.

L'intercalaire peut être :
- une couche déposée sur la cathode couche mince déposée par dépôt physique en phase vapeur, voire une colle si le réflecteur est une plaque (inox etc)...
- de l'air, le réflecteur étant écarté par des espaceurs, périphériques à la zone active,
- un film rapporté, par exemple un intercalaire de feuilletage (type PVB) et le réflecteur est par exemple un substrat verre avec une couche réfléchissante.

L'intercalaire de préférence comprend voire est constituée d'une (mono)couche (notamment d'épaisseur inférieure à 100 nm, épaisseur ajustée en fonction de son absorption) qui est
o minérale, de préférence choisie parmi un nitrure, un oxyde, un oxynitrure, par exemple un nitrure de silicium,
o ou une résine par exemple identique à la résine de passivation des bords d'OLED, notamment en polyimide,
o et/ou éventuellement est diffusante par exemple par ajout de particules diffusantes notamment minérales dans un liant notamment minéral.

De préférence, dans cette première configuration, le premier contact de cathode comprend une couche à base du même matériau que l'élément couvrant métallique, de préférence qui est une couche à base d'aluminium.

Le contact de cathode peut être :
- une couche déposée sur la cathode : colle conductrice, couche déposée par jet d'encre ou sérigraphie selon la forme souhaitée, couche mince déposée par PVD et si nécessaire patternée, une brasure voire une soudure ...
- et /ou un film rapporté avec la forme prédéterminée : clinquant ...

Le contact de cathode, de préférence à couche, est à base d'au moins un métal de préférence choisi parmi Al, Ag, Cu, Mo, Cr.

Notamment, le contact de cathode et I'l'élément couvrant réfléchissant peuvent être formés par une couche continue sur l'intercalaire (en couche) et la cathode, et de préférence le contact de cathode, voire la couche continue, est à base du même matériau que la cathode, notamment l'aluminium.

De cette manière à l'état off, la couche continue peut former un miroir et on ne différencie par le contact de cathode de l'élément couvrant.

On peut souhaiter utiliser une seule technique de dépôt (par exemple physique en phase vapeur PVD, notamment pulvérisation cathodique ou évaporation) pour l'élément couvrant et le contact de cathode (et même la cathode ou encore l'intercalaire), voire même une seule étape de dépôt de couche pour l'élément couvrant et le contact de cathode.

Plus largement, parmi les matériaux possibles pour la cathode on peut citer
- des métaux : aluminium, béryllium, magnésium, calcium, strontium, baryum, lanthane hafnium, indium, bismuth,
- et des lanthanides : cérium, praséodyme, néodyme, samarium, europium, gadolinium, terbium, dysprosium, holmium, erbium, thulium, ytterbium, et lutétium.

On préfère en particulier l'aluminium, l'argent, le baryum, le calcium, le samarium qui sont souvent utilisés pour leur faible travail de sortie.

Le tableau 1 ci-dessous donne
la R2 de l'aluminium (qui peut être transparent ou semi transparent en fonction de l'épaisseur choisie),
la R2 du samarium, de résistivité (massique) de 900 nOhm.m, qui peut être transparent ou semi transparent en fonction de l'épaisseur choisie et
la R2 du baryum, de résistivité (massique) de 332 nOhm.m, qui est transparent ou semi transparent en fonction de l'épaisseur choisie.

**Tableau 1**

| Epaisseur (nm) | R2 (Ω/□) pour Al | Epaisseur (nm) | R2 (Ω/□) pour Ba | Epaisseur (nm) | R2 (Ω/□) pour Sm |
|---|---|---|---|---|---|
| 10 | 5 | 5 | 66 | 10 | 90 |
| 20 | 2,5 | 10 | 33 | 50 | 18 |
| 50 | 1 | 30 | 11 | 100 | 9 |
| 100 | 0,5 | 50 | 6 | 200 | 4,5 |
| 200 | 0,25 | 75 | 4 | | |
| 500 | 0,1 | 100 | 3 | | |

On préfère que R2 soit supérieure ou égale à 1 voire à 3 ohm/carré et inférieure à 20 ohm/carré.

La cathode de manière préférée est à base d'au moins un métal, de préférence choisi parmi Al et Ag, avec optionnellement une couche de LiF sous jacente à la couche de métal et par exemple d'épaisseur < à 3 nm.

Tout particulièrement la cathode peut comprendre, voire est constituée, d'une couche à base d'aluminium et le contact de cathode est une couche à base d'aluminium, formant par exemple une surépaisseur sur la couche de cathode en aluminium.

Dans une deuxième configuration (avec la cathode transparente ou semi transparente), le réflecteur est un miroir de Bragg, miroir de Bragg agencé sur la cathode et adjacent au contact de cathode, et le contact de cathode fait partie du réflecteur.

Le miroir de Bragg est connu comme un empilement formé d'une alternance de couches minces haut indice de réfraction n1, telles que TiO2, ZrO2, Al2O3, Si3N4, et de couches minces de plus bas indice n2, telles que SiO2, CaF2.

Par exemple le delta d'indice n2-n1 est d'au moins 0,3, et de préférence d'au moins 0,6, et l'empilement comprend au moins deux couches haut indice et deux couches bas indice.

Ainsi, pour une OLED de longueur d'onde centrée vers 570 nm, on pourra envisager un empilement multicouche TiO2 60 nm / SiO2 95 nm, voire éventuellement la superposition de cet empilement multicouche.

L'utilisation de miroirs de Bragg pour des OLEDs est bien connue de l'homme du métier, qui pourra éventuellement se référer aux publications suivantes :
- Appl. Phys. Lett. 69, 1997 (1996); Efficiency enhancement of microcavity organic light emitting diodes ; R. H. Jordan, A. Dodabalapur, and R. E. Slusher,
- JOSA B, Vol. 17, Issue 1, pp. 114-119 (2000),Semitransparent metal or distributed Bragg reflector for wide-viewing-angle organic light-emitting-diode microcavities; Kristiaan Neyts, Patrick De Visschere, David K. Fork, and Greg B. Anderson

Le contact de cathode peut toucher le miroir de Bragg.

Le contact de cathode est connecté par exemple par l'une de ses extrémités dépassantes de la zone active formant alors une zone de connectique cathode.

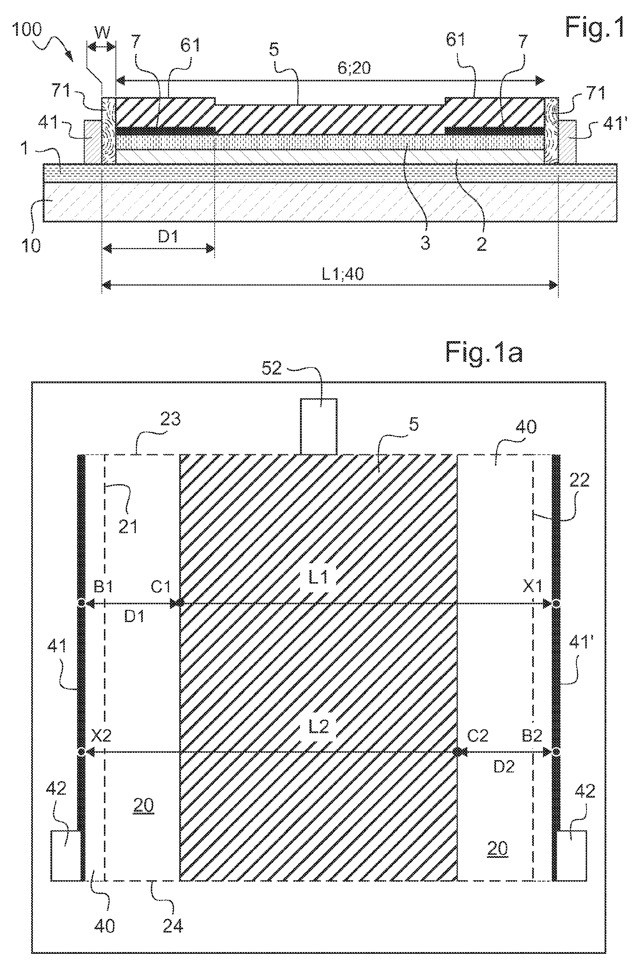

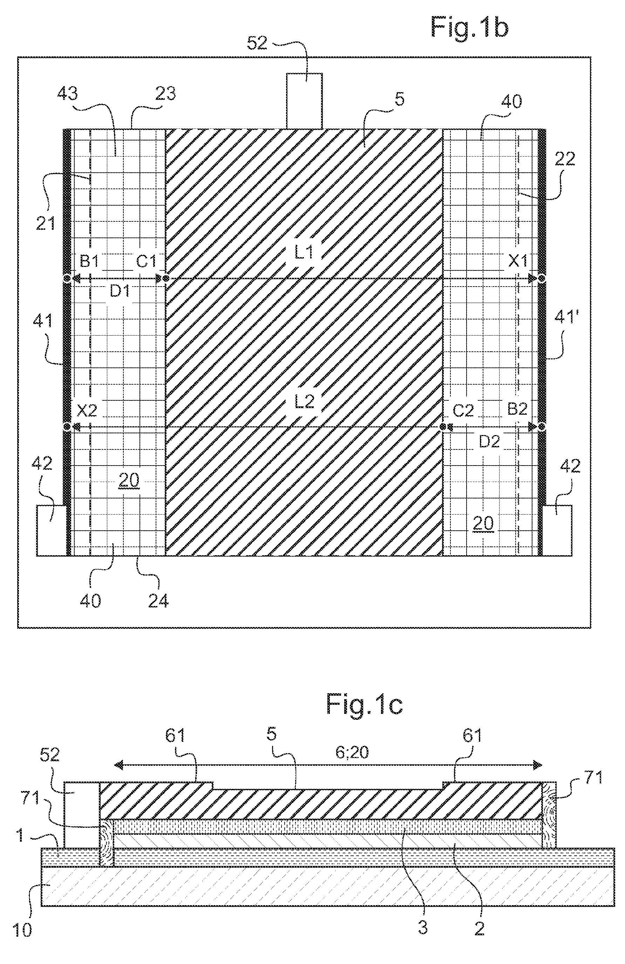

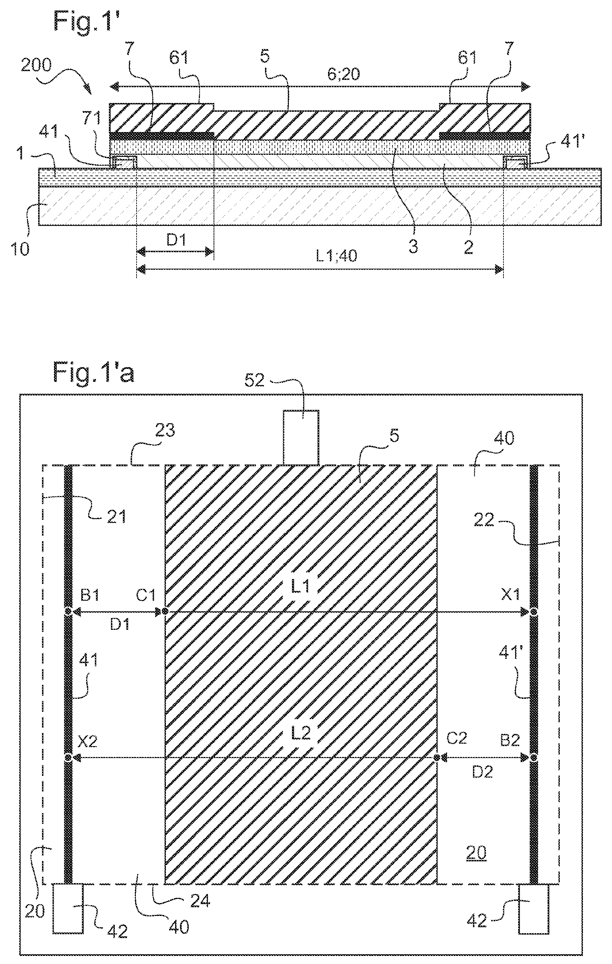

L'invention sera maintenant décrite plus en détails à l'aide d'exemples non limitatifs et de figures
- La figure 1 est une vue schématique en coupe d'un dispositif OLED conforme à l'invention
- La figure 1a est une vue schématique de dessus du dispositif OLED de la figure 1, montrant les contacts d'anode et de cathode
- La figure 1b est une vue schématique de dessus du dispositif OLED de la figure 1 dans une variante,
- La figure 1c est une autre vue schématique en coupe du dispositif OLED de la figure 1, montrant la connectique de cathode,
- La figure 1' est une vue schématique en coupe d'un dispositif OLED conforme à l'invention,
- La figure 1'a est une vue schématique de dessus du dispositif OLED de la figure 1', montrant les contacts d'anode et de cathode,
- La figure 2 est une vue schématique en coupe d'un dispositif OLED conforme à l'invention,
- La figure 2a est une vue schématique de dessus du dispositif OLED de la figure 2, montrant les contacts d'anode et de cathode,
- La figure 3 montre les graphes d'homogénéités de la luminance en fonction de D1/L1,
- Les figures 4 à 6b sont des vues schématiques de dessus des dispositifs OLED, montrant les contacts d'anode et de cathode avec différentes formes de zones actives.

On précise que par souci de clarté les différents éléments des objets (y compris les angles) représentés ne sont pas reproduits à l'échelle.

La figure 1, volontairement très schématique, représente en coupe un dispositif électroluminescent organique à émission à travers le substrat ou « bottom émission » en anglais.

Le dispositif OLED 100 (connectable en série aisément) comporte un substrat transparent avec une première face principale 10 comportant un empilement comprenant dans cet ordre en partant de ladite première face :
- une électrode inférieure formant anode 1, qui est transparente, comportant de préférence au moins une couche électroconductrice, anode de résistance par carré donné R1, par exemple un TCO ou un empilement à l'argent,
- un système électroluminescent organique 2 au-dessus de l'anode, (incluant couche HTL et ETL),
- une électrode supérieure formant cathode 3, transparente ou semi-réfléchissante, au-dessus du système électroluminescent organique, comportant une couche électroconductrice, cathode de résistance par carré donné R2 d'épaisseur donnée constante, le ratio r = R2/R1 allant de 0, 1 à 5, l'empilement définissant ainsi une zone commune, dite active 20.

Un potentiel V, par exemple 4 V ou 10 V, est appliqué en bordure de l'anode 1 via deux premier et deuxièmes contacts électrique d'anode 41, 41' périphériques, en (multi)couches métalliques par exemple. Ils sont dits adaptés c'est-à-dire de résistance électrique adaptée pour être, en fonctionnement, au potentiel V en tout point.

Le premier contact adapté 41 est ici à l'extérieur de la zone active 20 sur un premier bord 21 longitudinal de la zone active.

Le deuxième contact adapté 41 est ici à l'extérieur de la zone active 20 sur un deuxième bord 21 longitudinal de la zone active opposé au premier bord 22 (voir figure 1 a).

L'invention consiste ainsi en un module OLED dont à la fois le ratio r (ou r') et la géométrie des connexions électriques sur les deux électrodes sont ajustés de façon à ce que les chutes de tension qui ont lieu dans les deux électrodes se compensent pour maintenir une différence de tension la plus uniforme possible entre les deux électrodes.

Pour tout point B1 du premier contact d'anode adapté 41, en définissant une distance D1 entre ledit point B1 et le point C1 de la surface de contact le plus proche dudit point B, et en définissant une distance L1 entre ledit point B1 et un point X1 du deuxième contact adapté 41', en passant par C1, alors on définit les critères suivants :
- si 0,1 ≤ r < 1,75, alors 10% < D1/L1 < 50%,
- si 1,75 ≤ r < 2,5, alors 10% < D1/L1 < 45%,
- si 2,5 ≤ r < 3, alors 10% < D1/L1 < 40%,
- si 3 ≤ r ≤ 5, alors 10% < D1/L1 < 35%,
pour chaque point B2 du deuxième contact adapté 41, en définissant une distance D2 entre ledit point B2 et le point C2 de la surface de contact le plus proche dudit point B2, et en définissant une distance L2 entre ledit point B2 et un point X2 du premier contact adapté 41, en passant par C2, alors on définit les critères suivants :
- si 0,1 ≤ r < 1,75, alors 10% < D2/L2 < 50%,
- si 1,75 ≤ r < 2,5, alors 10% < D2/L2 < 45%,
- si 2,5 ≤ r < 3, alors 10% < D2/L2 < 40%,
- si 3 ≤ r ≤ 5, alors 10% < D2/L2 < 35%.

Et mieux encore
- si 0,1 ≤ r < 1,75, alors 20% ≤ D1/L1 < 50% et 20% ≤ D2/L2 < 50%,
- si 1,75 ≤ r < 2,5, alors 20% ≤ D1/L1 ≤ 40% et 20% ≤ D2/L2 ≤ 40%,
- si 2,5 ≤ r < 3, alors 20% ≤ D1/L1 ≤ 35% et 20% ≤ D2/L2 ≤ 35%,
- si 3 ≤ r ≤ 5, alors 15% ≤ D1/L1 ≤ 25% et 15% ≤ D2/L2 ≤25%.

Plus rigoureusement, D1 (respectivement D2) est la distance entre B1 (respectivement B2) et la projection orthogonale de C1 (respectivement de C2) dans le plan passant par B1 (respectivement B2) parallèle à l'anode. Et plus rigoureusement L1 (respectivement L2) est la distance entre B1 (respectivement B2) et X1 (respectivement X2), en passant par la projection orthogonale de C1 (respectivement de C2) dans le plan passant par B1 (respectivement B2) parallèle à l'anode. On peut préférer donc définir D1 et L1 dans le plan passant par B1 parallèle à l'anode et définir D2 et L2 dans le plan passant par B2 parallèle à l'anode.

La surface de contact est ici une surface pleine, en variante elle est en grille.

Le dispositif OLED 100 comporte au-dessus du système électroluminescent organique 2, en s'éloignant de la première face 10, un réflecteur 6 couvrant la zone active 20.

Plus précisément, le réflecteur 6 comporte un élément couvrant réfléchissant métallique 61, au-dessus de la cathode 3 en s'éloignant de la première face principale, l'élément couvrant 61 étant séparé de la cathode 3 par un élément électriquement isolant électrique 7 dit intercalaire, transparente et peu absorbante, ici une couche de préférence minérale et mince, telle que 50 nm de nitrure de silicium.

Le premier contact de cathode 5, adjacent à l'intercalaire 7, est réfléchissant, fait donc partie du réflecteur 6 et est de préférence en contact voire électriquement couplé à l'élément couvrant réfléchissant 61.

Le contact de cathode 5 est de préférence à base du même matériau que l'élément couvrant métallique 61. Le contact de cathode 5 et le réflecteur couvrant 6 sont alors formés par une couche continue sur l'intercalaire 7 et la cathode 3 par exemple par dépôt physique en phase vapeur. De préférence cette couche continue est à base d'aluminium par exemple de 100 nm, voire de 500 nm d'épaisseur. Naturellement l'intercalaire 7 a été structuré avant le dépôt pour laisser une zone libre correspondant à la zone destinée à être la zone du contact de cathode.

Les bords de la zone active 20 sont par exemple passivés par de la résine polyimide par exemple 71.

Les contacts d'anode 41, 41' sont ici sur l'anode 1 donc déposés préalablement sur le substrat (ou sur une couche sous jacente). Toutefois, l'anode 2 peut tout aussi bien être déposée après les contacts d'anode 41, 41' et les recouvrir partiellement pour sa liaison électrique.

En variante non représentée, le réflecteur comporte un miroir de Bragg adjacent audit premier contact de cathode. Le contact de cathode, réfléchissant, fait alors toujours partie du réflecteur. Le miroir de Bragg (en matériaux diélectriques) peut être directement sur la cathode.

La cathode 3 est par exemple une couche d'aluminium, notamment de R2 supérieure ou égale à 1 ohm/carré, voire supérieure ou égale à 3 ohm/carré et inférieure à 20 ohm/carré voire à 10 ohm/carré, le contact de cathode est alors de préférence une couche à base d'aluminium, comme déjà indiquée.

La zone active 20 est par exemple d'au moins 5 cm par 5 cm.

La figure 1a illustre une vue schématique de dessus du dispositif 100 montrant une partie des éléments du dispositif pour plus de clarté, à savoir les éléments à fonction électrique.

Le contact de cathode 5, rectangulaire, s'étend sur des premier et deuxième bords libres 23, 24 de la zone active 20 et est contacté en dehors de la zone active au-delà du bord libre 22 et par exemple est déposé sur ou sous un plot de contact 52 (voir figure 1c).

Les premier et deuxième contacts adaptés d'anode 41 sont des bandes rectilignes parallèles. La zone active 20 (définie ici simplement par ses contours, en pointillés), est carrée.

Les bords 23, 24 de la zone active adjacents aux premier et deuxième bords ne sont donc pas pourvus de contacts d'anode.

A titre illustratif, on a tracé un point B1 du premier contact d'anode, le point C1 du contact de cathode 5 le plus proche du point B1, et le point X1 du deuxième bord 22. La droite passant par B1, par la projection orthogonale de C1 dans le plan de B1 parallèle à l'anode et passant par X1, permet de définie au mieux L1 et D1.

A titre illustratif, on a tracé un point B2 du deuxième contact d'anode 41', le point C2 du contact de cathode 5 le plus proche du point B2, et le point X2 du premier bord 21. La droite passant par B2, par la projection orthogonale de C2 dans le plan de B2 parallèle à l'anode et passant par X2, permet de définir au mieux L2 et D2.

Pratiquement l'espace entre le premier contact adapté 41 et le premier bord 21 est restreint. Le premier contact adapté périphérique externe est de préférence à une distance W inférieure à L/10 voire à L/20 du premier bord où L est la distance entre premier et deuxième bords 21 et 22 ici constante (égale à L1).

Pratiquement l'espace entre le deuxième contact adapté 41 et le deuxième bord 22 est restreint. Le deuxième contact adapté périphérique externe est de préférence à une distance W inférieure à L/10 voire à L/20 du deuxième bord.

On choisit L = 15 cm, Rorg = 300 Ohm.cm², une anode de 3 Ohm/carré, et on définit l'homogénéité H de la luminance comme le rapport entre la luminance minimale sur la luminance maximale pour une OLED alimentée à une tension donnée au-dessus de la tension d'allumage de l'OLED.

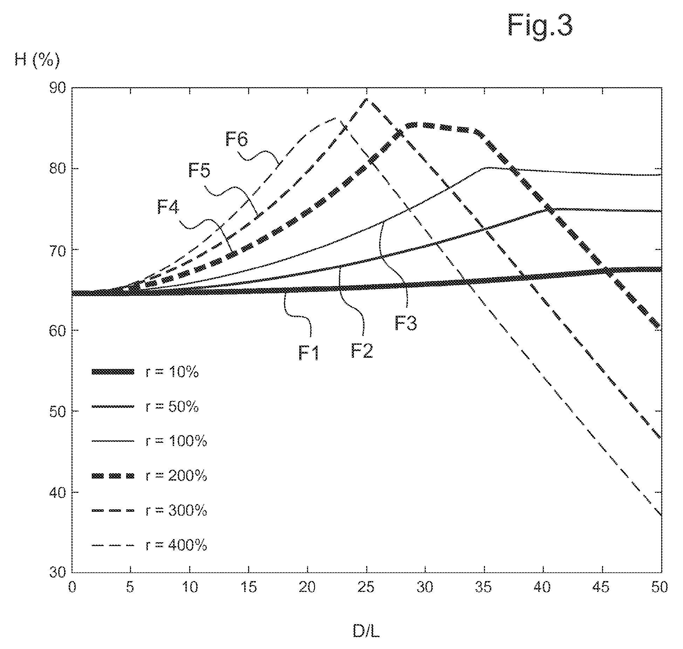

La figure 3 montre les graphes d'homogénéité H en fonction de D1/L1 du contact de cathode 5 du dispositif 100 montré en figure 1, pour différents ratios r (entre 0,1 et 4).

On y voit six courbes F1 à F6 d'homogénéité H (en %) respectivement pour r = 0,1 ; r = 0,5 ; r = 1 ; r = 2 ; r =3 ; r = 4.

Ces graphes F1 à F6 rappellent les plages de paramètres qui conviennent pour D1/L1, en particulier vers les r bas, la plage optimale est plus étroite mais H est meilleur.

Les résultats pour H sont similaires (suivent la même tendance) avec une Rorg différente, typiquement entre 50 et 300 Ohm.cm², une anode de R1 différente typiquement entre 1 et 10 ohm par carré, et pour toute autre taille de zone active.

On choisit par exemple r = 3 et D1/L1 = 25% avec une anode en ITO de R1 = 8 Ohm par carré et une cathode de R2 = 24 Ohm par carré; ou encore une anode à l'argent de R1 = 3 Ohm par carré et une cathode de R2 = 9 Ohm par carré.

On peut aussi choisir un r plus faible, pour des facilités de fabrication, par exemple avec r = 1 et D/L = 35% => avec une anode en ITO de R1 = 8 Ohm par carré et une cathode de R2 = 8 Ohm par carré; ou encore une anode à l'argent de R1 = 3 Ohm - cathode de R2 = 3 Ohm par carré.

Pour réaliser une anode de R1 égale à 3 ohm par carré, on préfère un empilement à l'argent plutôt qu'un oxyde transparent conducteur « TCO », tel que ITO. On peut citer par exemple les empilements monocouche à l'argent ou bicouche à l'argent décrits dans les demandes WO 2008/029060 et WO 2009/083693.

Pour réaliser la cathode, on dépose de l'aluminium en ajustant l'épaisseur.

La figure 1b est une vue schématique de dessus du dispositif OLED de la figure 1 dans une variante.

On ajoute des contacts électriques d'anode 43 résistifs, en couche électroconductrice, reliés aux contacts d'anode adaptés 41, 41'. Ici ces contacts résistifs 43 sont interconnectés et forment une grille.

Aussi pour obtenir une bonne homogénéité d'éclairement, le ratio r est remplacé par un ratio r' = R2/R'1 dans laquelle R'1 est la résistance par carré équivalente de l'ensemble anode et contact(s) d'anode résistif(s), c'est-à-dire la mise en parallèle de l'anode et des contacts d'anode résistifs.

Le contact résistif d'anode peut être en un même matériau que les contacts adaptés mais beaucoup plus fin par exemple de moins de 1 mm. Par exemple, un maillage carré de brins métalliques d'une période de 5 mm, réalisé à l'aide de fils d'aluminium de 500 nm de hauteur et de 100 µm de largeur forme un système ayant une résistance par carré équivalente de 2,7 ohm par carré. Si un tel maillage est placé sur une anode d'ITO de résistance par carré de 20 ohm par carré, la résistance équivalente de l'anode (définie comme la résistance résultant de la mise en parallèle de l'anode et des contacts résistifs), est alors de 2,4 ohm par carré. En réalisant sur cette anode une OLED de zone active carrée de 8x8 cm², ayant une résistance verticale des matériaux organiques de 100 ohm.cm², l'éclairement sera à proximité d'un contact résistif situé à 4 cm du bord de l'OLED sera 20% plus faible. Cette diminution de l'éclairement supérieure à 5% est attribuée au caractère résistif des contacts résistifs qui engendrent une diminution de la tension de l'anode au centre de l'OLED, engendrant la chute d'éclairement.

La figure 1' est une vue schématique en coupe d'un dispositif OLED 200 conforme à l'invention.

Il diffère du premier dispositif 100 en ce que les contacts d'anode 41, 41' longent la périphérie des bords en interne. La zone active 20 est donc plus grande que la première région anodique 40.

La figure 1'a est une vue schématique de dessus du dispositif OLED de la figure 1', montrant les contacts d'anode et de cathode similaires à ceux montrés en figure 1a.

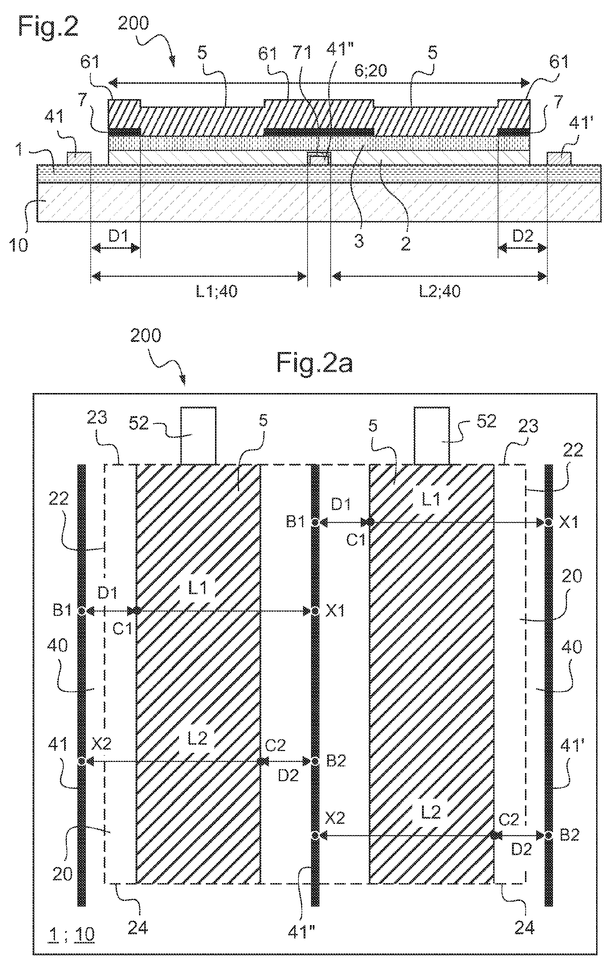

La figure 2 est une vue schématique en coupe d'un dispositif OLED 300 conforme à l'invention.

Il diffère du premier dispositif 100 en ce qu'il y a un contact d'anode interne médian ; équidistant par exemple, des premier et deuxième contacts d'anode 41, 41'.

On définit donc une première région anodique 40 avec le premier contact périphérique 41 et le contact médian 41" et une deuxième région anodique 40' avec le contact médian et le deuxième contact adapté périphérique.

La zone active 20 est donc plus grande que la première région anodique 40.

On place dans chaque région anodique 40, 40' un premier contact de cathode 5, ici rectangulaire espacé des contacts d'anode pour satisfaire aux ratios D1/L1 et D2/L2 en fonction du r choisi (même r pour toutes les régions anodiques de préférence).

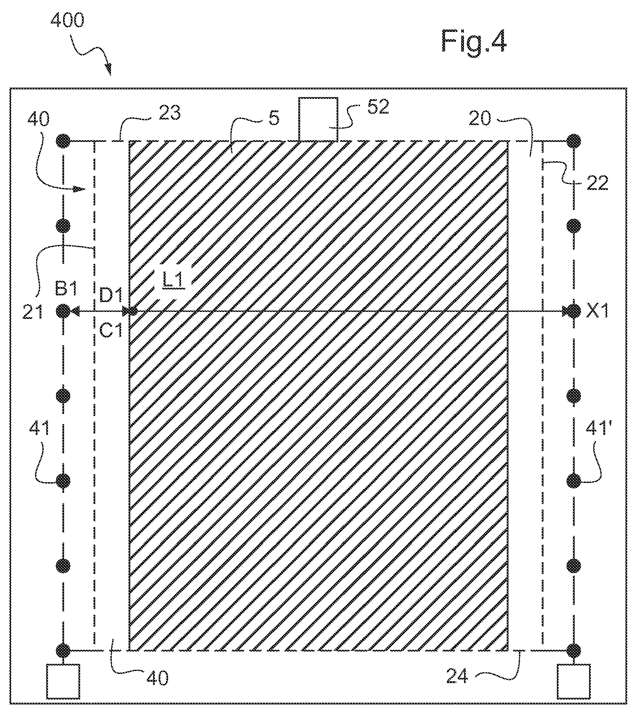

La figure 4 est une vue schématique de dessus d'un dispositif OLED 400 conforme à l'invention, montrant les contacts d'anode et de cathode.

Il diffère du premier dispositif 100 en ce que les premier et deuxième contacts d'anode adaptés 41, 41' ne sont plus des bandes mais chacun un ensemble de contacts ponctuels suffisamment rapprochés toujours le long d'un bord longitudinal de la zone active.

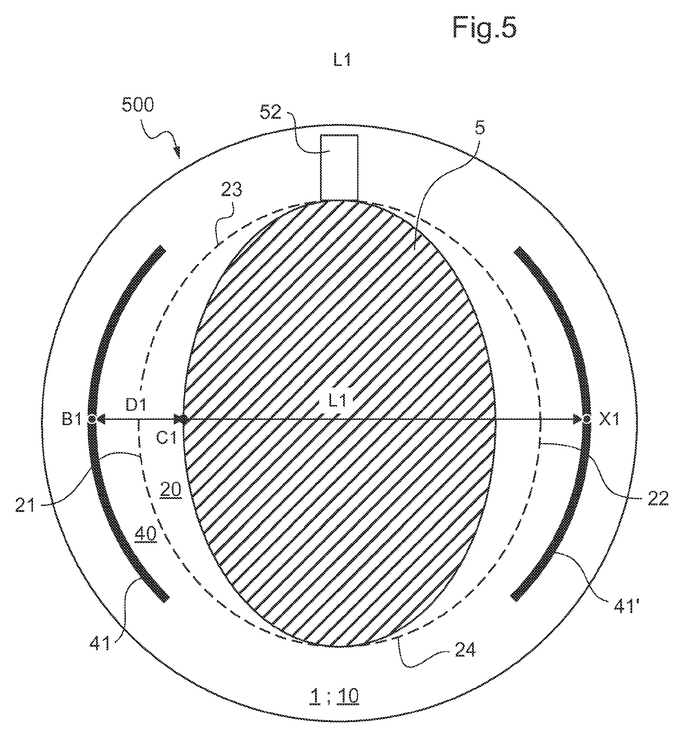

La figure 5 est une vue schématique de dessus d'un dispositif OLED 500 conforme à l'invention, montrant les contacts d'anode et de cathode.

Il diffère du premier dispositif 100 en ce que la zone active 20 est ronde (ovoïde par exemple) les premier et deuxième contacts d'anode adaptés 41, 41' ne sont plus des bandes rectangulaires mais en forme de C donnant une première région anodique également ronde 40.

Le premier contact de cathode est également de forme arrondie par exemple à distance constante des contacts adaptés 41, 41'.

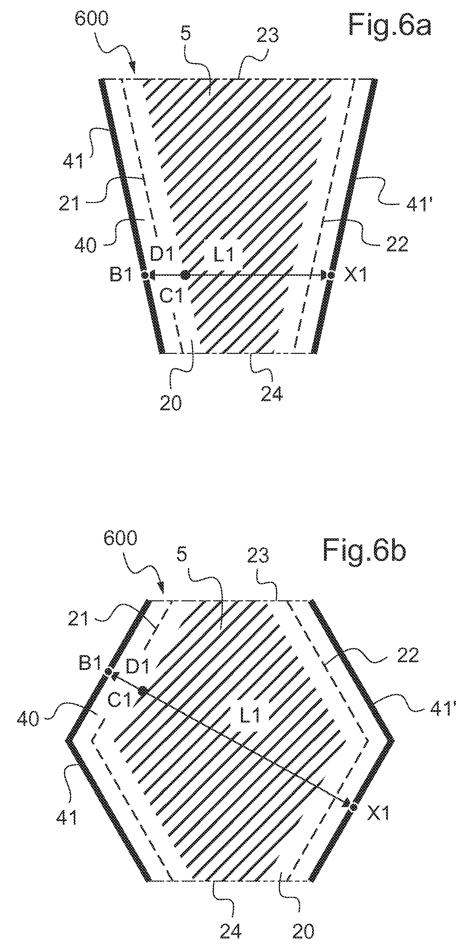

La figure 6a est une vue schématique de dessus d'un dispositif OLED 600 conforme à l'invention, montrant les contacts d'anode et de cathode.

Il diffère du premier dispositif 100 en ce que la zone active 20 (et la première région anodique 40) est un quadrilatère et le contact de cathode 5 l'est aussi. Les premier et deuxième contacts restent sur les bords les plus longs 21, 22.

La figure 6b est une vue schématique de dessus d'un dispositif OLED 600' conforme à l'invention, montrant les contacts d'anode et de cathode.

Il diffère du premier dispositif 100 en ce que la zone active 20 (et la première région anodique 40) est un hexagone et le contact de cathode 5 l'est aussi. Les premier et deuxième contacts d'anode 41, 41' sont chacun sur deux cotés adjacents 21,22 formant ainsi en quelque sorte des bords longitudinaux. Ils restent deux cotés ou bords libres 23, 24.

## Revendications

1. Dispositif à diode électroluminescente organique, dit OLED, (100 à 600') comportant un substrat transparent (10) avec une première face principale comportant un empilement comprenant dans cet ordre en partant de ladite première face :
- une électrode inférieure formant anode (1), qui est transparente, anode de résistance par carré donnée R1,
- un système électroluminescent organique (2) au-dessus de l'anode,
- une électrode supérieure formant cathode (3), au-dessus du système électroluminescent organique, comportant une couche électroconductrice, cathode (3) de résistance par carré donnée R2, le ratio r = R2/R1 allant de 0,1 à 5,
l'anode, le système électroluminescent organique et la cathode définissant ainsi une zone commune dite active (20)
le dispositif OLED comportant,
- un premier contact d'anode dit adapté (41),
- un deuxième contact d'anode dit adapté (41'), espacé et en regard du premier contact adapté,
les premier et deuxième contacts d'anode adaptés (41, 41') formant deux côtés opposés d'une première région de l'anode (1), dite première région anodique (40, 40'), délimitée en outre par un premier bord dit libre (23) de la zone active (20) et par un deuxième bord dit libre (24) de la zone active (20) opposé au premier bord libre (23),
- un premier contact électrique de cathode (5), qui est :
- agencé au-dessus de la zone active (20), couvrant partiellement la région de la cathode (3) au-dessus de la première région anodique (40),
- de surface donnée, dite surface de contact, inférieure à la superficie de la zone active et à la superficie de la première région anodique,
- décalé du premier contact d'anode adapté (41) et du deuxième contact d'anode adapté (41'), en tout point de la surface de contact
pour chaque point B1 du premier contact adapté (41), en définissant une distance D1 entre ledit point B1 et la projection orthogonale, dans le plan passant par B1 parallèle à l'anode, du point C1 de la surface de contact le plus proche dudit point B1, et en définissant une distance L1 entre ledit point B1 et un point X1 du deuxième contact adapté (41'), en passant par la projection orthogonale de C1 dans le plan passant par B1 parallèle à l'anode, alors on définit les critères suivants :
- si 0,1 ≤ r < 1,75, alors 10% < D1/L1 < 50%,
- si 1,75 ≤ r < 2,5, alors 10% < D1/L1 < 45%,
- si 2,5 ≤ r < 3, alors 10% < D1/L1 < 40%,
- si 3 ≤ r ≤ 5, alors 10% < D1/L1 < 35%,
pour chaque point B2 du deuxième contact adapté (41'), en définissant une distance D2 entre ledit point B2 et la projection orthogonale, dans le plan passant par B2 parallèle à l'anode, du point C2 de la surface de contact le plus proche dudit point B2, et en définissant une distance L2 entre ledit point B2 et un point X2 du premier contact adapté (41), en passant par la projection orthogonale de C2 dans le plan passant par B2 parallèle à l'anode, alors on définit les critères suivants :
- si 0,1 ≤ r < 1,75, alors 10% < D2/L2 < 50%,
- si 1,75 ≤ r < 2,5, alors 10% < D2/L2 < 45%,
- si 2,5 ≤ r < 3, alors 10% < D2/L2 < 40%,
- si 3 ≤ r ≤ 5, alors 10% < D2/L2 < 35%,
et le dispositif OLED 100 comporte au-dessus du système électroluminescent organique (2), en s'éloignant de la première face (10), un réflecteur (6) couvrant la zone active (20).

2. Dispositif OLED (100 à 600') selon la revendication précédente **caractérisé en ce que** la surface de contact (5) s'étend depuis le centre de la première région anodique (40) vers les premier et deuxième contacts d'anode (41, 41').

3. Dispositif OLED (100 à 600') selon l'une des revendications précédentes **caractérisé en ce que** la surface de contact (5) est une surface pleine, une surface en grille.

4. Dispositif OLED (100 à 600') selon l'une des revendications précédentes **caractérisé en ce que** le premier contact de cathode (5) est de préférence centré par rapport au premier contact d'anode adapté (41) et au deuxième contact d'anode adapté (41').

5. Dispositif OLED (100 à 600') selon l'une des revendications précédentes **caractérisé en ce que** le premier contact de cathode (5), notamment centré, a une surface homothétique à la surface de la première région anodique (40) et/ou à la surface de la zone active (20).

6. Dispositif OLED (100 à 600') selon l'une des revendications précédentes **caractérisé en ce que**
- si 0,1 ≤ r < 1,75, alors 20% ≤ D1/L1 < 50% et 20% ≤ D2/L2 < 50%,
- si 1,75 ≤ r < 2,5, alors 20% ≤ D1/L1 ≤ 40% et 20% ≤ D2/L2 ≤ 40%,
- si 2,5 ≤ r < 3, alors 20% ≤ D1/L1 ≤ 35% et 20% ≤ D2/L2 ≤ 35%,
- si 3 ≤ r ≤ 5, alors 15% ≤ D1/L1 ≤25% et 15% ≤ D2/L2 ≤25%.

7. Dispositif OLED (100 à 600') selon l'une des revendications précédentes **caractérisé en ce que** le premier contact d'anode adapté (41), notamment en bande, est le long d'un premier bord (21) de la zone active (20), et éventuellement le deuxième contact d'anode adapté (41'), notamment en bande, est le long d'un deuxième bord (22) de la zone active opposée au premier bord (21), notamment les premier et deuxième bords (21, 22) sont longitudinaux.

8. Dispositif OLED (100 à 600') selon l'une des revendications précédentes **caractérisé en ce que** le premier contact d'anode adapté (41) est sensiblement rectiligne et de préférence défini par un premier plan moyen M1 et le deuxième contact d'anode adapté (41') est sensiblement rectiligne et de préférence défini par un deuxième plan moyen M2, et de préférence l'angle α entre les plans moyens M1 et M2 étant inférieur à 45°, voire inférieur ou égal à 30°.

9. Dispositif OLED (100) selon l'une des revendications précédentes **caractérisé en ce que** le dispositif OLED comprend un ou des contacts électriques d'anode dits résistifs (43), agencés dans la première région anodique (40) et **en ce que** le ratio r allant de 0,1 à 5 est remplacé par un ratio r'= R2/R'1 allant de 0,1 à 5 dans lequel R'1 est la résistance par carré équivalente de l'ensemble anode (1) et contact(s) d'anode résistif(s) (42) dans la première région anodique (40).

10. Dispositif OLED (100 à 600') selon l'une des revendications précédentes **caractérisé en ce que** la cathode (3) étant transparente ou semi-réfléchissante, le réflecteur (6) comporte un élément couvrant réfléchissant (61), de préférence métallique, notamment en couche, au-dessus de la cathode (3) en s'éloignant de la première face principale, l'élément couvrant (61) étant séparé de la cathode par un élément isolant électrique (7) dit intercalaire, et **en ce que** le premier contact de cathode (5), adjacent à l'intercalaire (7), fait partie du réflecteur (6) et est de préférence en contact voire électriquement couplé à l'élément couvrant réfléchissant (61).

11. Dispositif OLED (100 à 600') selon la revendication 10 **caractérisé en ce que** le premier contact de cathode (5) est à base du même matériau que l'élément couvrant réfléchissant (61), de préférence à base d'aluminium, notamment le premier contact de cathode (5) et l'élément couvrant (61) sont formés par une couche continue (6) sur l'intercalaire (7).

12. Dispositif OLED (100 à 600') selon la revendication 11 **caractérisé en ce que** la couche continue (6), est à base du même matériau que la cathode (3), notamment l'aluminium.

13. Dispositif OLED (100 à 600') selon la revendication précédente **caractérisé en ce que** la cathode (3) comprend une couche à base d'aluminium et le premier contact de cathode (5) comprend une couche à base d'aluminium.

14. Dispositif OLED selon l'une des revendications 1 à 13 **caractérisé en ce que** le réflecteur comporte un miroir de Bragg, adjacent au premier contact de cathode, et le premier contact de cathode fait partie du réflecteur.

## Patentansprüche

1. Organische Leuchtdioden-Vorrichtung, so genannte OLED, (100 bis 600'), die ein transparentes Substrat (10) aufweist mit einer ersten Hauptseite, die eine Aufschichtung aufweist, die in dieser Reihenfolge ausgehend von der ersten Seite Folgendes umfasst:
- eine untere Elektrode, die eine Anode (1) bildet und transparent ist, wobei die Anode einen gegebenen spezifischen Flächenwiderstand R1 hat,
- ein organisches elektrolumineszierendes System (2) oberhalb der Anode,
- eine obere Elektrode, die eine Kathode (3) bildet, oberhalb des organischen elektrolumineszierenden Systems, die eine elektrisch leitfähige Schicht aufweist, wobei die Kathode (3) einen gegebenen spezifischen Flächenwiderstand R2 hat, wobei das Verhältnis r = R2/R1 von 0,1 bis 5 beträgt,
wobei die Anode, das organische elektrolumineszierende System und die Kathode so eine gemeinsame, so genannte aktive Zone (20) definieren,
wobei die OLED-Vorrichtung Folgendes aufweist:
- einen ersten, so genannten angepassten Anodenkontakt (41),
- einen zweiten, so genannten angepassten Anodenkontakt (41'), der von dem ersten angepassten Kontakt beabstandet ist und diesem gegenüberliegt,
wobei der erste und zweite angepasste Anodenkontakt (41, 41') zwei entgegengesetzte Seiten einer ersten Region der Anode (1), der so genannten ersten anodischen Region (40, 40'), bilden, die ferner durch einen ersten so genannten freien Rand (23) der aktiven Zone (20) und durch einen zweiten so genannten freien Rand (24) der aktiven Zone (20), der zu dem ersten freien Rand (23) entgegengesetzt ist, begrenzt wird,
- einen ersten elektrischen Kathodenkontakt (5), der:
- oberhalb der aktiven Zone (20) angeordnet ist, wobei er die Region der Kathode (3) oberhalb der ersten anodischen Region (40) teilweise bedeckt,
- eine gegebene Oberfläche, die so genannte Kontaktoberfläche, hat, die kleiner ist als die Oberfläche der aktiven Zone und als die Oberfläche der ersten anodischen Region,
- von dem ersten angepassten Anodenkontakt (41) und von dem zweiten angepassten Anodenkontakt (41') versetzt ist, an jeder Stelle der Kontaktoberfläche,
[wobei] für jeden Punkt B1 des ersten angepassten Kontakts (41), durch Definieren eines Abstands D1 zwischen dem Punkt B1 und der orthogonalen Projektion,
in der Ebene, die B1 parallel zu der Anode durchläuft, von dem Punkt C1 der Kontaktoberfläche, der dem Punkt B1 am nächsten ist, und durch Definieren eines Abstands L1 zwischen dem Punkt B1 und einem Punkt X1 des zweiten angepassten Kontakts (41`), durch Durchlaufen der orthogonalen Projektion von C1 in der Ebene, die B1 parallel zu der Anode durchläuft, dann die folgenden Kriterien definiert werden:
- wenn 0,1 ≤ r < 1,75, dann 10 % < D1/L1 < 50 %,
- wenn 1,75 ≤ r < 2,5, dann 10 % < D1/L1 < 45 %,
- wenn 2,5 ≤ r < 3, dann 10 % < D1/L1 < 40%,
- wenn 3 ≤ r ≤ 5, dann 10 % < D1/L1 < 35 %,
[wobei] für jeden Punkt B2 des zweiten angepassten Kontakts (41'), durch Definieren eines Abstands D2 zwischen dem Punkt B2 und der orthogonalen Projektion, in der Ebene, die B2 parallel zu der Anode durchläuft, von dem Punkt C2 der Kontaktoberfläche, der dem Punkt B2 am nächsten ist, und durch Definieren eines Abstands L2 zwischen dem Punkt B2 und einem Punkt X2 des ersten angepassten Kontakts (41), durch Durchlaufen der orthogonalen Projektion von C2 in der Ebene, die B2 parallel zu der Anode durchläuft,
dann die folgenden Kriterien definiert werden:
- wenn 0,1 ≤ r < 1,75, dann 10 % < D2/L2 < 50 %,
- wenn 1,75 ≤ r < 2,5, dann 10 % < D2/L2 < 45 %,
- wenn 2,5 ≤ r < 3, dann 10 % < D2/L2 < 40 %,
- wenn 3 ≤ r ≤ 5, dann 10 % < D2/L2 < 35 %,
und die OLED-Vorrichtung (100) oberhalb des organischen elektrolumineszierenden Systems (2), sich von der ersten Fläche (10) entfernend, einen Reflektor (6) aufweist, der die aktive Zone (20) bedeckt.

2. OLED-Vorrichtung (100 bis 600') nach dem vorhergehenden Anspruch, **dadurch gekennzeichnet, dass** sich die Kontaktfläche (5) von dem Zentrum der ersten anodischen Region (40) zu dem ersten und zweiten Anodenkontakt (41, 41') hin erstreckt.

3. OLED-Vorrichtung (100 bis 600') nach einem der vorhergehenden Ansprüche, **dadurch gekennzeichnet, dass** die Kontaktfläche (5) eine voll ausgefüllte Oberfläche, eine gitterförmige Oberfläche ist.

4. OLED-Vorrichtung (100 bis 600') nach einem der vorhergehenden Ansprüche, **dadurch gekennzeichnet, dass** der erste Kathodenkontakt (5) vorzugsweise relativ zu dem ersten angepassten Anodenkontakt (41) und zu dem zweiten angepassten Anodenkontakt (41') zentriert ist.

5. OLED-Vorrichtung (100 bis 600') nach einem der vorhergehenden Ansprüche, **dadurch gekennzeichnet, dass** die erste, insbesondere zentrierte Kontaktfläche (5) eine Oberfläche hat, die zu der Oberfläche der ersten anodischen Region (40) und/oder zu der Oberfläche der aktiven Zone (20) homothetisch ist.

6. OLED-Vorrichtung (100 bis 600') nach einem der vorhergehenden Ansprüche, **dadurch gekennzeichnet, dass**
- wenn 0,1 ≤ r < 1,75, dann 20 % ≤ D1/L1 < 50 % und 20 % ≤ D2/L2 < 50 %,
- wenn 1,75 ≤ r < 2,5, dann 20 % ≤ D1/L1 ≤ 40 % und 20 % ≤ D2/L2 ≤ 40 %,
- wenn 2,5 ≤ r < 3, dann 20 % ≤ D1/L1 ≤ 35 % und 20 % ≤ D2/L2 ≤ 35 %,
- wenn 3 ≤ r ≤ 5, dann 15 % ≤ D1/L1 ≤ 25 % und 15 % ≤ D2/L2 ≤ 25 %.

7. OLED-Vorrichtung (100 bis 600') nach einem der vorhergehenden Ansprüche, **dadurch gekennzeichnet, dass** der erste angepasste, insbesondere bandförmige Anodenkontakt (41) entlang eines ersten Rands (21) der aktiven Zone (20) ist und gegebenenfalls der zweite angepasste, insbesondere bandförmige Anodenkontakt (41') entlang eines zweiten Rands (22) der aktiven Zone (20) ist, die zu dem ersten Rand (21) entgegengesetzt ist, insbesondere der erste und zweite Rand (21, 22) längsgerichtet sind.

8. OLED-Vorrichtung (100 bis 600') nach einem der vorhergehenden Ansprüche, **dadurch gekennzeichnet, dass** der erste angepasste Anodenkontakt (41) im Wesentlichen geradlinig ist und vorzugsweise durch eine erste Mittelebene M1 definiert ist, und der zweite angepasste Anodenkontakt (41') im Wesentlichen geradlinig ist und vorzugsweise durch eine zweite Mittelebene M2 definiert ist und wobei vorzugsweise der Winkel α zwischen den Mittelebenen M1 und M2 kleiner als 45° oder sogar kleiner oder gleich 30° ist.

9. OLED-Vorrichtung (100) nach einem der vorhergehenden Ansprüche, **dadurch gekennzeichnet, dass** die OLED-Vorrichtung einen oder mehrere elektrische, so genannte ohmsche Anodenkontakte (43) umfasst, die in der ersten anodischen Region (40) angeordnet sind, und dass das Verhältnis, das von 0,1 bis 5 beträgt, durch ein Verhältnis r'= R2/R'1, das von 0,1 bis 5 beträgt, ersetzt wird, wobei R'1 der äquivalente spezifische Flächenwiderstand der Anordnung aus Anode (1) und ohmschem/n Kontakt(en) (42) in der ersten anodischen Region (40) ist.

10. OLED-Vorrichtung (100 bis 600') nach einem der vorhergehenden Ansprüche, **dadurch gekennzeichnet, dass**, da die Kathode (3) transparent oder halb-reflektierend ist, der Reflektor (6) sich von der ersten Hauptseite entfernend ein reflektierendes Abdeckelement (61) vorzugsweise aus Metall, insbesondere schichtförmig, oberhalb der Kathode (3) aufweist, wobei das Abdeckelement (61) von der Kathode durch ein elektrisches isolierendes Element (7), das so genannte Zwischenelement, getrennt ist und dass der erste Kathodenkontakt (5), der an das Zwischenelement (7) angrenzt, Teil des Reflektors (6) ist und mit dem reflektierenden Abdeckelement (61) vorzugsweise in Kontakt oder sogar elektrisch gekoppelt ist.

11. OLED-Vorrichtung (100 bis 600') nach Anspruch 10, **dadurch gekennzeichnet, dass** der erste Kathodenkontakt (5) auf Basis des gleichen Materials ist wie das reflektierende Abdeckelement (61), vorzugsweise auf Aluminiumbasis, insbesondere der erste Kathodenkontakt (5) und das Abdeckelement (61) durch eine durchgängige Schicht (6) auf dem Zwischenelement (7) gebildet sind.

12. OLED-Vorrichtung (100 bis 600') nach Anspruch 11, **dadurch gekennzeichnet, dass** die durchgängige Schicht (6) auf Basis des gleichen Materials ist wie die Kathode (3), insbesondere Aluminium.

13. OLED-Vorrichtung (100 bis 600') nach dem vorhergehenden Anspruch, **dadurch gekennzeichnet, dass** die Kathode (3) eine Schicht auf Aluminiumbasis umfasst und der erste Kathodenkontakt (5) eine Schicht auf Aluminiumbasis umfasst.

14. OLED-Vorrichtung nach einem der Ansprüche 1 bis 13, **dadurch gekennzeichnet, dass** der Reflektor einen Bragg-Spiegel an den ersten Kathodenkontakt angrenzend aufweist und der erste Kathodenkontakt Teil des Reflektors ist.

## Claims

1. So-called OLED organic light-emitting diode device, (100 to 600') comprising a transparent substrate (10) with a first main face comprising a stack comprising in this order, starting from said first face:
- a lower electrode forming an anode (1), which is transparent, anode of given sheet resistance R1,
- an organic light-emitting system (2) above the anode,
- an upper electrode forming a cathode (3), above the organic light-emitting system, comprising an electroconducting layer, cathode (3) of given sheet resistance R2, the ratio r = R2/R1 ranging from 0.1 to 5,
the anode, the organic light-emitting system and the cathode thus defining a, so-called active, common zone (20),
the OLED device comprising,
- a first so-called tailored anode contact (41),
- a second so-called tailored anode contact (41'), spaced from and facing the first tailored contact,
the first and second tailored anode contacts (41, 41') forming two opposite sides of a first region of the anode (1), termed the first anodic region (40, 40'), furthermore delimited by a first so-called free edge (23) of the active zone (20) and by a second so-called free edge (24) of the active zone (20) opposite from the first free edge (23),
- a first cathode electrical contact (5), which is:
- arranged above the active zone (20), partially covering the region of the cathode (3) above the first anodic region (40),
- of given surface, termed the contact surface, smaller than the surface area of the active zone and than the surface area of the first anodic region,
- offset from the first tailored anode contact (41) and from the second tailored anode contact (41'), at every point of the contact surface
for each point B1 of the first tailored contact (41), on defining a distance D1 between said point B1 and the orthogonal projection, in the plane passing through B1 parallel to the anode, of that point C1 of the contact surface which is closest to said point B1, and on defining a distance L1 between said point B1 and a point X1 of the second tailored contact (41'), passing through the orthogonal projection of C1 in the plane passing through B1 parallel to the anode, then the following criteria are defined:
- if 0.1 ≤ r < 1.75, then 10% < D1/L1 < 50%,
- if 1.75 ≤ r < 2.5, then 10% < D1/L1 < 45%,
- if 2.5 ≤ r < 3, then 10% < D1/L1 < 40%,
- if 3 ≤ r ≤ 5, then 10% < D1/L1 < 35%,
for each point B2 of the second tailored contact (41'), on defining a distance D2 between said point B2 and the orthogonal projection, in the plane passing through B2 parallel to the anode, of that point C2 of the contact surface which is closest to said point B2, and on defining a distance L2 between said point B2 and a point X2 of the first tailored contact (41), passing through the orthogonal projection of C2 in the plane passing through B2 parallel to the anode, then the following criteria are defined:
- if 0.1 ≤ r < 1.75, then 10% < D2/L2 < 50%,
- if 1.75 ≤ r < 2.5, then 10% < D2/L2 < 45%,
- if 2.5 ≤ r < 3, then 10% < D2/L2 < 40%,
- if 3 ≤ r ≤ 5, then 10% < D2/L2 < 35%,
and the OLED device (100) comprises above the organic light-emitting system (2), on moving away from the first face (10), a reflector (6) covering the active zone (20).

2. OLED device (100 to 600') according to the preceding claim, **characterized in that** the contact surface (5) extends from the center of the first anodic region (40) to the first and second anode contacts (41, 41').

3. OLED device (100 to 600') according to either of the preceding claims, **characterized in that** the contact surface (5) is a solid surface, a grid-like surface.

4. OLED device (100 to 600') according to one of the preceding claims, **characterized in that** the first cathode contact (5) is preferably centered with respect to the first tailored anode contact (41) and to the second tailored anode contact (41').

5. OLED device (100 to 600') according to one of the preceding claims, **characterized in that** the first cathode contact (5), in particular centered, has a surface homothetic to the surface of the first anodic region (40) and/or to the surface of the active zone (20).

6. OLED device (100 to 600') according to one of the preceding claims, **characterized in that**
- if 0.1 ≤ r < 1.75, then 20% ≤ D1/L1 < 50% and 20% ≤ D2/L2 < 50%,
- if 1.75 ≤ r < 2.5, then 20% ≤ D1/L1 ≤ 40% and 20% ≤ D2/L2 ≤ 40%,
- if 2.5 ≤ r < 3, then 20% ≤ D1/L1 ≤ 35% and 20% ≤ D2/L2 ≤ 35%,
- if 3 ≤ r ≤ 5, then 15% ≤ D1/L1 ≤25% and 15% ≤ D2/L2 ≤25%.

7. OLED device (100 to 600') according to one of the preceding claims, **characterized in that** the first tailored anode contact (41), in particular band-like, is along a first edge (21) of the active zone (20), and optionally the second tailored anode contact (41'), in particular band-like, is along a second edge (22) of the active zone opposite from the first edge (21), in particular the first and second edges (21, 22) are longitudinal.

8. OLED device (100 to 600') according to one of the preceding claims, **characterized in that** the first tailored anode contact (41) is substantially rectilinear and preferably defined by a first mid-plane M1 and the second tailored anode contact (41') is substantially rectilinear and preferably defined by a second mid-plane M2, and preferably the angle α between the mid-planes M1 and M2 being less than 45°, or indeed less than or equal to 30°.

9. OLED device (100) according to one of the preceding claims, **characterized in that** the OLED device comprises one or more so-called resistive anode electrical contacts (43), arranged in the first anodic region (40) and **in that** the ratio r ranging from 0.1 to 5 is replaced with a ratio r'= R2/R'1 ranging from 0.1 to 5 in which R'1 is the equivalent sheet resistance of the assembly of anode (1) and resistive anode contact(s) (42) in the first anodic region (40).

10. OLED device (100 to 600') according to one of the preceding claims, **characterized in that** the cathode (3) being transparent or semi-reflecting, the reflector (6) comprises a reflecting covering element (61), preferably metallic, in particular layer-like, above the cathode (3) on moving away from the first main face, the covering element (61) being separated from the cathode by a so-called insert electrical insulating element (7), and **in that** the first cathode contact (5), adjacent to the insert (7), forms part of the reflector (6) and is preferably in contact or indeed electrically coupled with the reflecting covering element (61).

11. OLED device (100 to 600') according to Claim 10, **characterized in that** the first cathode contact (5) is based on the same material as the reflecting covering element (61), preferably based on aluminum, in particular the first cathode contact (5) and the covering element (61) are formed by a continuous layer (6) on the insert (7).

12. OLED device (100 to 600') according to Claim 11, **characterized in that** the continuous layer (6) is based on the same material as the cathode (3), in particular aluminum.

13. OLED device (100 to 600') according to the preceding claim, **characterized in that** the cathode (3) comprises a layer based on aluminum and the first cathode contact (5) comprises a layer based on aluminum.

14. OLED device according to one of Claims 1 to 13, **characterized in that** the reflector comprises a Bragg mirror, adjacent to the first cathode contact, and the first cathode contact forms part of the reflector.
